# EUROPÄISCHE PATENTSCHRIFT

(11) **EP 0 499 049 B1**
(45) Veröffentlichungstag und Bekanntmachung des Hinweises auf die Patenterteilung: **22.05.1996**
(21) Anmeldenummer: 92100891.8
(22) Anmeldetag: 21.01.1992
(51) Int. Cl.: H01L 39/14, H01L 39/24

(54) **Oxidkeramischer supraleitender Verbundkörper und Verfahren zu seiner Herstellung**
Oxide ceramic superconducting composite device and fabrication method
Dispositif composite supraconducteur en céramique d'oxyde et procédé pour sa fabrication

(30) Priorität: 14.02.1991 DE 4104421; 23.04.1991 DE 4113220
(43) Veröffentlichungstag der Anmeldung: 19.08.1992
(73) Patentinhaber: VACUUMSCHMELZE GMBH, D-63412 Hanau (DE)
(72) Erfinder: Tenbrink, Johannes, Dr., W-8752 Mömbris (DE); Heine, Klaus, Dr., W-6053 Obertshausen (DE); Puniska, Paul, W-6451 Neuberg 1 (DE); Schmitt, Christine, W-4300 Essen 17 (DE)
(74) Vertreter: Fuchs, Franz-Josef, Dr.-Ing.

(56) Entgegenhaltungen:
- EP-A- 0 290 331
- EP-A- 0 308 326
- WO-A-88/08618
- DE-A- 3 731 266
- DE-A- 3 817 693
- US-A- 4 863 804
- CRYOGENICS. Bd. 30, Nr. SUP., September 1990, GUILDFORD GB, Seiten 846-850; J. CHIKABA: "Fabrication of aluminium bronze-sheathed YBa2Cu3Ox superconducting wires"
- PATENT ABSTRACTS OF JAPAN, vol. 014, no. 134 (C-0701) 14. März 1990 & JP-A-2 008 335

## Beschreibung

Die Erfindung betrifft einen supraleitenden Verbundkörper nach dem Oberbegriff des Patentanspruchs 1 sowie ein Verfahren zu seiner Herstellung.

Supraleitende Verbundkörper, bei denen ein oxidkeramisches supraleitendes Pulver von einem Hüllmaterial umschlossen ist, sind beispielsweise aus der Veröffentlichung von H. Krauth und A. Szulczyk in METALL, Jg. 45, H. 5 (1989), Seiten 418 ff. bekannt. Durch die Verwendung oxidkeramischer Hochtemperatursupraleiter (HTSL) werden Verbundkörper, wie Drähte oder Bänder hergestellt, die auch oberhalb der Temperatur des flüssigen Stickstoffs supraleitend sind. Die hierzu geeigneten Materialien sind an sich bekannt. Hierzu gehören beispielsweise Phasen in den Systemen YBaCuO, BiSrCaCuO und TlBaCaCuO.

Zur Herstellung technischer Leiter werden diese supraleitenden Pulver beispielsweise in ein Metallrohr eingefüllt. Anschließend wird durch Verformung ein Draht oder ein Band hergestellt. Abschließend wird eine Wärmebehandlung durchgeführt, die der Herstellung einer durchgehend supraleitenden Verbindung durch das HTSL-Material und der Optimierung der kritischen Stromdichte dient. Da die supraleitenden Eigenschaften der oxidischen Hochtemperatursupraleiter stark durch ihren Sauerstoffgehalt beeinflußt werden, sollte vorteilhafterweise die Einstellung des optimalen Sauerstoffgehaltes während der abschließenden Wärmebehandlung erfolgen. Dies bedeutet, daß die Sauerstoffpermeation durch das Hüllmaterial gewährleistet sein muß. Als geeignetes Hüllmaterial hat sich Silber erwiesen. Silber weist jedoch den Nachteil auf, daß es mechanisch sehr weich ist. Dies führt aufgrund des härteren Kerns aus oxidkeramischem Supraleitermaterial bei der Herstellung des Verbundkörpers leicht zu einer ungleichmäßigen Verformung des Kerns. Außerdem weist Silber nach den für die Erzeugung der optimalen supraleitenden Eigenschaften des Kerns notwendigen Glühungen eine geringe mechanische Festigkeit auf.

In der PCT-Anmeldung WO 88/08618 wurde daher vorgeschlagen, auf dem Verbundkörper eine weitere äußere Schicht aus Stahl anzubringen. Durch die Stahlschicht wurde jedoch die Sauerstoffpermeation soweit verringert, daß der Verbundkörper nicht mehr supraleitend war. Deshalb wurde dort weiterhin vorgeschlagen, auf die Silberhülle eine Nitratbeschichtung aufzubringen oder eine Sandwich-Struktur mit verschiedenen Materialkombinationen zu wählen. Die Herstellung eines solchen Supraleiters ist durch die zusätzlich erforderlichen Schritte zur Aufbringung weiterer Hüllschichten jedoch kompliziert und arbeitsaufwendig.

Aus der EP-OS 290 331 ist es bekannt, daß anstatt Silber auch Silberlegierungen als Hüllmaterialien verwendet werden können. Genannt sind dort AgCu-Legierungen mit Kupfergehalten zwischen 2,8 % und 30 %.

Ebenfalls ist es aus der DE-OS 38 17 693 bekannt, bei einem oxidischen Supraleiter das Pulver mit einer Hülle zu versehen und als Hüllmaterial Legierungen auf Silberbasis beispielsweise mit bis zu 10 % der Legierungselemente aus der Gruppe Palladium, Platin und Ruthenium sowie Zusätze aus der Gruppe Chrom, Nickel und Zirkon zu verwenden. Allerdings ist hier nichts über eine oxiddisperse Aushärtung bzw. Härtbarkeit erwähnt.

In der DE-OS 37 31 266 werden als Hüllmaterialien für supraleitende Verbundkörper Silberlegierungen offenbart, deren Schmelzpunkt über dem Schmelzpunkt von reinem Silber liegt. Hierdurch soll es ermöglicht werden, die Wärmebehandlung bei Temperaturen durchzuführen, die oberhalb des Schmelzpunktes von reinem Silber liegen. Als geeignete Silberlegierungen werden Legierungen genannt, bei denen dem Silber mindestens eines der Elemente der Gruppe Gold, Palladium, Platin, Mangan und Titan zulegiert wird.

Aufgabe der Erfindung ist es, einen supraleitenden Verbundkörper anzugeben, dessen Hüllmaterial einerseits eine hohe Sauerstoffpermeation aufweist, dessen mechanische Eigenschaften aber deutlich besser sind als bei reinem Silber.

Die Aufgabe wird bei einem gattungsgemäßen Verbundkörper dadurch gelöst, daß als Hüllmaterial eine oxiddispers gehärtete bzw. härtbare Silberlegierung verwendet wird.

Dispersionsgehärtete Silberlegierungen sind an sich bekannt und werden beispielsweise in der Elektrotechnik als Kontaktwerkstoffe eingesetzt. Diese Legierungen weisen gegenüber Silber verbesserte mechanische Werte, wie eine erhöhte Härte und Festigkeit auf. Insbesondere sind Legierungen mit feindispersen Oxidausscheidungen geeignet. Sowohl die Schmelztemperatur als auch die Sauerstoffpermeation werden durch die geringen Legierungszusätze praktisch nicht verändert. Die zur Härtung durch Oxidausscheidung beitragenden Legierungselemente sollen daher bis zu maximal 10 Gew.-% in der Legierung enthalten sein, vorzugsweise jedoch von 0,05 bis 2 Gew.-%.

Besonders geeignet sind oxiddispers gehärtete bzw. härtbare AgMgNi-, AgMnNi- und AgAl-Legierungen. Im Falle der AgMgNi-Legierungen enthält die Legierung vorzugsweise 0,1 bis 0,25 Gew.% Mg, 0,1 bis 0,25 Gew.-% Ni, Rest Silber. Für die AgMnNi-Legierungen sollte der Gesamtgehalt an Mn und Ni vorzugsweise etwa 0,5 bis 1,5 Gew.-% betragen.

Zur Erhöhung des elektrischen Widerstands kann jeweils ein Teil des Silbers auch durch mindestens eines der Edelmetallelemente (EM) Ru, Rh, Pd, Os, Ir, Pt und/oder Au ersetzt werden. Die guten mechanischen Eigenschaften aufgrund der Ausscheidungshärtung bleiben dabei erhalten. Um die hohe Sauerstoffpermeation des Hüllmaterials zu erhalten, sollte der Silbergehalt vorzugsweise mindestens 80 Gew.-% betragen. Der Anteil der widerstandserhöhenden Edelmetalle (EM) sollte daher nicht mehr als 10 Gew.-% betragen. Als besonders vorteilhaft hinsichtlich der Sauerstoffpermeation wird die Verwendung des Edelmetallelements Palladium als Legierungsbestandteil angesehen.

Bei den erfindungsgemäß verwendeten Silberlegierungen erfolgt die Härtung durch innere Oxidation. Dies kann durch eine Wärmebehandlung in Luft oder Sauerstoff enthaltender Atmosphäre erzielt werden. Bei den AgMgNi-Legierungen beispielsweise führt diese Wärmebehandlung zur Ausscheidung von Magnesiumoxidpartikeln. Die feine Dispersion dieser harten Komponente verleiht der Legierung ihre hohe Festigkeit. Der Nickelanteil dient aufgrund seiner begrenzten Löslichkeit in Silber zur Kornverfeinerung. Die Festigkeit dieser Legierung im ausgehärteten Zustand ist typischerweise doppelt so hoch wie im unausgehärteten Zustand, dessen Festigkeit mit der von reinem Silber vergleichbar ist. Auch die Härte von AgMgNi-Legierungen von typischerweise 130 HV ist bereits bei Raumtemperatur deutlich höher als die von reinem Silber (etwa 80 HV). Der Unterschied wird aber deutlich größer bei erhöhten Temperaturen, die bei der Herstellung des Verbundkörpers beispielsweise bei einer Warmverformung oder den Wärmebehandlungen auftreten. Nach Glühung bei 600 °C weist reines Silber eine Härte von nur noch 25 HV auf, während die Härte der beispielhaft genannten bereits durchoxidierten AgMgNi-Legierung praktisch unverändert ist.

Der elektrische Widerstand der genannten Ag-Legierungen entspricht im wesentlichen dem von reinem Silber. Insbesondere bei Wechselfeldanwendungen wird zur Verlustreduzierung ein Hüllmaterial mit höherem spezifischen Widerstand gewünscht. Wie bereits erwähnt, kann dies durch den Zusatz mindestens eines der Edelmetalle (EM) Ru, Rh, Pd, Os, Ir, Pt oder Au erreicht werden. Die Werte für den spezifischen elektrischen Widerstand der erfindungsgemäßen Hüllmaterialien werden dabei im wesentlichen durch den spez. Widerstand der entsprechenden Legierungen ohne die durch Oxidausscheidung die Härtung bewirkenden Elemente bestimmt. Die Widerstandserhöhung binärer Silberlegierungen durch die Edelmetallelemente Au und Pd ist beispielsweise im Edelmetall-Taschenbuch der DEGUSSA AG, Frankfurt/M. 1967, Seiten 91 bis 93 angegeben. Sie beträgt jeweils 0,3 µΩ cm pro at.-% Au bzw. Pd im Konzentrationsbereich von 1 bis 5 at.-% Au bzw Pd bei 20 °C. Der spezifische Widerstand von reinem Silber beträgt 1,5 µΩ cm.

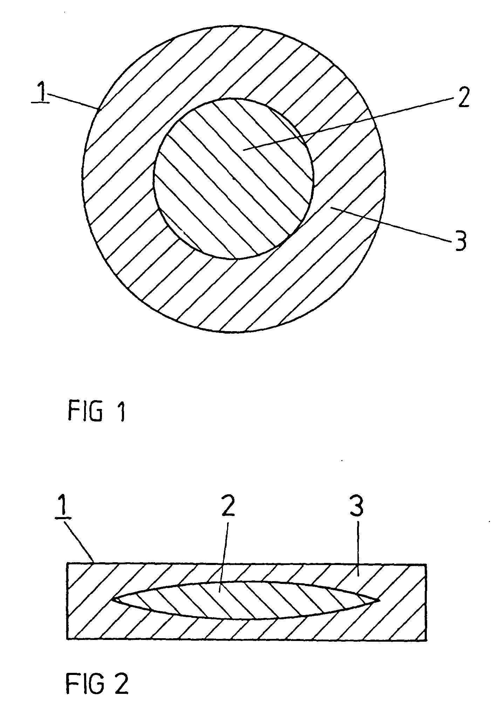

In den Fig. 1 und 2 sind erfindungsgemäße supraleitende Verbundkörper 1 dargestellt und zwar in Fig. 1 als Draht und in Fig. 2 als Band. Der Verbundkörper besteht aus einem Kern des oxidkeramischen Supraleitermaterials 2 und einer äußeren Hülle 3, die von einer oxiddispers gehärteten bzw. härtbaren Silberlegierung gebildet wird. Der Verbundkörper kann auch als Multifilamentleiter ausgebildet sein. Bei einem Multifilamentleiter sind entsprechend mehrere Kerne aus HTSL-Material in einer Matrix aus der oxiddispers gehärteten oder härtbaren Ag-Legierung angeordnet.

Der erfindungsgemäße Verbundkörper wird derart hergestellt, daß zunächst das oxidkeramische Supraleitermaterial 2 in die Hülle 3 aus einer oxiddispers gehärteten bzw. härtbaren Silberlegierung eingebracht wird. Unter dem Begriff oxidkeramisches Supraleitermaterial werden hierbei auch solche oxidkeramische Materialien verstanden, die erst nach Durchführung des gesamten Herstellungsverfahrens, insbesondere der Schlußglühungen ihre supraleitenden Eigenschaften erhalten. Die Hülle mit dem darin enthaltenen Supraleitermaterial wird anschließend einer querschnittsreduzierenden Verformung unterzogen. Hierbei handelt es sich insbesondere um das Strangpressen, das Hämmern, das Ziehen, das Band- und Pilgerwalzen oder Abfolgen dieser Verfahren. Nachfolgend wird in an sich bekannter Weise eine Wärmebehandlung durchgeführt, die - wie oben beschrieben - zur optimalen Einstellung der supraleitenden Eigenschaften dient. Die Bedingungen für die entsprechenden Glühbehandlungen sind dem Fachmann bekannt.

Die Aushärtung des Hüllmaterials durch Oxidausscheidungen kann bereits vor dem Einfüllen des oxidkeramischen Materials vorgenommen werden. Dies ist besonders dann vorteilhaft, wenn im Verformungsschritt dünne Bänder hergestellt werden sollen, da dann durch die größere Härte des Hüllmaterials bessere Verformungseigenschaften gegeben sind. Andererseits kann die Aushärtung aber auch erst nach Erreichen der Enddimension vor der abschließenden Wärmebehandlung erfolgen. In diesem Fall wird der abschließenden Wärmebehandlung eine weitere Glühung vorgeschaltet, die zur Härtung des Hüllmaterials dient und dem Verbunddraht eine größere Festigkeit verleiht. Die Aushärtung kann bei Bedarf aber auch in einem Zwischenstadium erfolgen.

Die für die Drahtherstellung benötigten Rohre können auch durch Mischen von Ag-Pulver, feinkörnigem Oxidpulver und gegebenenfalls Edelmetallpulver und anschließender Weiterverarbeitung zu Rohren hergestellt werden. Dabei wird das Ag/Oxid-Pulvergemisch zu einem Bolzen verpreßt und dieser zum Beispiel durch Strangpressen zu einem Rohr umgeformt.

Um eine höhere Dichte des supraleitenden Ausgangsmaterials vor dem Einbringen in die Hülle zu erzielen, kann das oxidkeramische Supraleitermaterial zunächst, d. h. vor dem Einbringen in die Hülle, vorverdichtet werden. Dies erfolgt insbesondere durch kaltisostatisches Pressen. Der so hergestellte Preßkörper kann zusätzlich auch gesintert werden. Dies hat eine weitere Steigerung der Ausgangsdichte und der Festigkeit des Materials zur Folge. Vor dem Einbringen der so hergestellten Zylinder aus supraleitendem Material in die Hülle müssen diese Zylinder in der Regel zunächst überdreht werden. Nach dem Einfüllen des Materials in den Hüllkörper kann zusätzlich nach dem Evakuieren und Verschließen des Hüllkörpers ein weiteres kaltisostatisches Pressen des Verbundes erfolgen, um die Ausgangsdichte weiter zu erhöhen. Eine erhöhte Ausgangsdichte führt zu einer gleichmäßigeren Verformung und damit zu einer besseren Homogenität der Eigenschaften des supraleitenden Verbundkörpers.

Zur Herstellung des supraleitenden Verbundkörpers in Form eines dünnen Bandes hat sich insbesondere das Warmwalzen als querschnittsreduzierender Verformungsschritt als vorteilhaft erwiesen. Hierdurch kann eine wesentlich gleichmäßigere Verformung erzielt werden als beim Kaltwalzen. Beim Kaltwalzen können Inhomogenitäten des Querschnitts bis hin zu Unterbrechungen im supraleitenden Material durch zwischengequetschtes Hüllmaterial auftreten. Die Ursache für die günstigeren Verformungseigenschaften beim Heißwalzen wird darin gesehen, daß eine Verringerung des Härte-Unterschiedes durch eine Erweichung des supraleitenden Materials infolge der Annäherung an die Temperatur des partiellen Schmelzens erfolgt. Diese Temperatur liegt im Falle von Bi₂Sr₂Ca₁Cu₂O₈₊ₓ (2212-Phase), beispielsweise bei etwa 890 °C,
so daß für ein solches supraleitendes Material die Temperatur beim Heißwalzen vorzugsweise zwischen 500 und 800 °C, insbesondere zwischen 750 und 800 °C, liegt. Für das Heißwalzen kann die Temperatur des Verbundkörpers beispielsweise kurz vor dem Walzspalt, insbesondere durch induktive Erwärmung eines Graphitsuszeptors mit Spalt zum Durchziehen des Bandes erzielt werden.

In speziellen Ausführungsbeispielen wurden supraleitende Verbundkörper hergestellt, bei denen als oxidkeramisches Supraleitermaterial die 2212-Phase von BiSrCaCuO eingesetzt wurde. Als Hüllmaterialien wurden die Silberlegierungen Ag - Mg 0,15 - Ni 0,15 und Ag - Mg 0,25 - Ni 0,25 verwendet, die mehr als 99 % Silber enthalten. Die Härte der Ag - Mg 0,15 - Ni 0,15 - Legierung liegt im ausgehärteten Zustand bei 125 HV, im Falle der Ag - Mg 0,25 - Ni 0,25 - Legierung bei 135 HV (jeweils gemessen nach 24-stündiger Aushärtung bei 650 °C an Luft). Auch durch eine zusätzliche Langzeitglühung von bis zu 120 Stunden bei Temperaturen von teilweise mehr als 900 °C zeigte sich nur eine moderate Abnahme der Härte. Aus dem Pulver und dem Hüllmaterial wurden in an sich bekannter Weise Drähte mit einem Durchmesser von 1 mm hergestellt. Nach der Verformung lag das Flächenverhältnis von Ag-Legierungshülle zu Supraleiterkern bei etwa 1. Die Aushärtung der AgMgNi-Legierung erfolgte nach dem letzten Verformungsschritt durch eine 1-stündige Wärmebehandlung bei 650 °C an Luft. Anschließend wurde eine weitere an sich bekannte Wärmebehandlung zur Erhöhung und Einstellung der Sauerstoffkonzentration durchgeführt. Zum Vergleich wurden zusätzlich supraleitende Verbundkörper mit einer Hülle aus Feinsilber hergestellt. Es zeigte sich, daß die Streckgrenze R_{p0,1}, der erfindungsgemäßen Verbundkörper je nach Mg-Gehalt um einen Faktor 7 bis 9 höher ist als bei Verwendung von Feinsilber. Zudem wiesen die erfindungsgemäßen Drähte eine verbesserte Temperaturwechselbeständigkeit auf. Der E-Modul der Verbunddrähte wurde zu etwa 50 GPa bestimmt. Bei Verwendung der erfindungsgemäßen Hüllmaterialien wurden mit bis zu etwa 1000 A/cm (77K, OT) die gleiche kritische Stromdichte erreicht wie bei den Vergleichsdrähten.

Weitere naheliegende Ausgestaltungen der Erfindung sind dem Fachmann an sich bekannt. So können beispielsweise die Verbundkörper mit einer isolierenden Beschichtung versehen werden oder es können mehrere Verbundkörper zu einem Multifilamentverbundkörper kombiniert werden.

## Patentansprüche

1. Supraleitender Verbundkörper (1) aus einem oxidkeramischen Supraleitermaterial und einer äußeren aus einer Legierung auf Silberbasis bestehenden Hülle, **dadurch gekennzeichnet,** daß die als Hüllmaterial verwendete Legierung auf Silberbasis oxiddispers gehärtet bzw. härtbar ist, und daß die zur Härtung durch Oxidausscheidung beitragende Legierungsmenge bis zu 10 Gew.-% in der Legierung auf Silberbasis enthalten sind.

2. Verbundkörper nach Anspruch 1, **dadurch gekenzeichnet,** daß die zur Härtung durch Oxidausscheidung beitragenden Legierungselemente zu 0,05 bis 2 Gew.-% in der Legierung auf Silberbasis enthalten sind.

3. Verbundkörper nach Anspruch 1, **dadurch gekennzeichnet,** daß die Legierung auf Silberbasis zur Erhöhung des elektrischen Widerstandes mindestens eines der Edelmetallelemente (EM) Ru, Rh, Pd, Os, Ir, Pt und/oder Au enthält.

4. Verbundkörper nach Anspruch 3, **dadurch gekennzeichnet,** daß die Edelmetallelemente (EM) mit einem Gesamtgehalt von nicht mehr als 10 Gew.-% in der Silberlegierung enthalten sind.

5. Verbundkörper nach einem der vorhergehenden Ansprüche, **dadurch gekennzeichnet,** daß es sich bei der Silberlegierung um eine Ag-Mg-Ni- oder Ag-EM-Mg-Ni-Legierung handelt, die vorzugsweise 0,1 bis 0,25 Gew.-% Mg, 0,1 bis 0,25 Gew.-% Ni, Rest Silber bzw. Silber und Edelmetallelemente EM enthält.

6. Verbundkörper nach einem der Ansprüche 1 bis 4, **dadurch gekennzeichnet,** daß es sich bei der Silberlegierung um eine Ag-Mn-Ni- oder Ag-EM-Mn-Ni-Legierung handelt, die vorzugsweise Mn und Ni in einem Gesamtgehalt von 0,5 bis 1,5 Gew.-%, Rest Silber bzw. Silber und Edelmetallelemente EM enthält.

7. Verbundkörper nach einem der Ansprüche 1 bis 3, **dadurch gekennzeichnet,** daß es sich bei der Silberlegierung um eine Ag-Al- oder Ag-EM-Al-Legierung handelt.

8. Verbundkörper nach einem der vorhergehenden Ansprüche, **dadurch gekennzeichnet,** daß die Legierung auf Silberbasis als Edelmetallelement (EM) Palladium (Pd) enthält.

9. Verbundkörper nach einem der vorhergehenden Ansprüche, **dadurch gekennzeichnet,** daß die Silberlegierung durch Mischen von Pulvern, vorzugsweise eines Silberpulvers mit einem Oxidpulver und gegebenenfalls einem Edelmetallpulver hergestellt wird.

10. Verfahren zur Herstellung eines supraleitenden Verbundkörpers (1) durch
- Einbringen eines oxidkeramischen Supraleitermaterials (2) in eine Hülle (3), deren Material aus einer Legierung auf Silberbasis besteht,
- querschnittsreduzierendes Verformen und
- Wärmebehandeln zur Erholung und Einstellung der Sauerstoffkonzentration,
**dadurch gekennzeichnet,** daß die Hülle (3) aus einer oxiddispers gehärteten bzw. härtbaren Silberlegierung besteht, und daß die zur Härtung durch Oxidausscheidung beitragende Legierungsmenge bis zu 10 Gew.-% in der Legierung auf Silberbasis enthalten sind.

11. Verfahren nach Anspruch 10, **dadurch gekennzeichnet,** daß vor der Wärmebehandlung zur Erholung und Einstellung der Sauerstoffkonzentration eine weitere Wärmebehandlung zur Aushärtung der oxiddispers härtbaren Silberlegierung vorgenommen wird.

12. Verfahren nach Anspruch 10 oder 11, **dadurch gekennzeichnet,** daß das oxidkeramische Supraleitermaterial (2) vor dem Einbringen in die Hülle (3) vorverdichtet wird, insbesondere durch kaltisostatisches Pressen.

13. Verfahren nach Anspruch 12, **dadurch gekennzeichnet,** daß das verdichtete Supraleitermaterial (2) vor dem Einbringen in die Hülle (3) zusätzlich gesintert wird.

14. Verfahren nach einem der Ansprüche 10 bis 13, **dadurch gekennzeichnet,** daß das querschnittsreduzierende Verformen zu Beginn einen kaltisostatischen Preßschritt enthält.

15. Verfahren nach einem der Ansprüche 10 bis 14, **dadurch gekennzeichnet,** daß das querschnittsreduzierende Verformen auch durch Heißwalzen erfolgt.

16. Verfahren nach einem der Ansprüche 10 bis 15, **dadurch gekennzeichnet,** daß das querschnittsreduzierende Verformen auch durch Pilgerwalzen erfolgt.

## Claims

1. Superconducting composite device (1) consisting of a ceramic oxide superconductor material and an outer sheath made of a silver-based alloy, characterised in that the silver-based alloy used as the sheath material is oxide dispersion hardened or hardenable and in that the silver-based alloy contains up to 10% by weight of the alloy contributing to the hardening by oxide precipitation.

2. Composite device according to claim 1, characterised in that the silver-based alloy contains 0.05 to 2% by weight of the alloy elements contributing to the hardening by oxide precipitation.

3. Composite device according to claim 1, characterised in that the silver-based alloy contains at least one of the noble metal elements (EM) Ru, Rh, Pd, Os, Ir, Pt and/or Au to increase the electrical resistance.

4. Composite device according to claim 3, characterised in that the silver alloy contains a total of not more than 10% by weight of the noble metal elements (EM).

5. Composite device according to one of the preceding claims, characterised in that the silver alloy is an Ag-Mg-Ni or Ag-EM-Mg-Ni alloy which preferably contains 0.1 to 0.25% by weight Mg, 0.1 to 0.25% by weight Ni, with the remainder silver or silver and noble metal elements (EM).

6. Composite device according to one of claims 1 to 4, characterised in that the silver alloy is an Ag-Mn-Ni or Ag-EM-Mn-Ni alloy which preferably contains a total of 0.5 to 1.5% by weight of Mn and Ni, with the remainder silver or silver and noble metal elements (EM).

7. Composite device according to one of claims 1 to 3, characterised in that the silver alloy is an Ag-Al or Ag-EM-Al alloy.

8. Composite device according to one of the preceding claims, characterised in that the silver-based alloy contains palladium (Pd) as noble metal element (EM).

9. Composite device according to one of the preceding claims, characterised in that the silver alloy is produced by mixing powders, preferably a silver powder with an oxide powder and possibly a noble metal powder.

10. Process for the production of a superconducting composite device (1) by
- introducing a ceramic oxide superconductor material (2) into a sheath (3) the material of which consists of a silver-based alloy,
- cross section-reducing forming and
- heat treatment to restore and adjust the oxygen concentration,
characterised in that the sheath (3) consists of an oxide dispersion hardened or hardenable silver alloy and in that the silver-based alloy contains up to 10% by weight of the alloy contributing to the hardening by oxide precipitation.

11. Process according to claim 10, characterised in that the heat treatment to restore and adjust the oxygen concentration is preceded by a further heat treatment to harden the oxide dispersion hardenable silver alloy.

12. Process according to claim 10 or 11, characterised in that the ceramic oxide superconductor material (2) undergoes preliminary compression before it is introduced into the sheath (3), in particular by cold isostatic pressing.

13. Process according to claim 12, characterised in that the compressed superconductor material (2) is additionally sintered before it is introduced into the sheath (3).

14. Process according to one of claims 10 to 13, characterised in that the cross section-reducing forming comprises a cold isostatic pressing step at the start.

15. Process according to one of claims 10 to 14, characterised in that the cross section-reducing forming is also carried out by hot rolling.

16. Process according to one of claims 10 to 15, characterised in that the cross section-reducing forming is also carried out by pilger rolling.

## Revendications

1. Solide composite (1) supraconducteur à base d'un matériau supraconducteur en céramique d'oxyde et d'une coquille externe consistant en un alliage à base d'argent, caractérisé en ce que l'alliage utilisé en tant que matériau d'enveloppe, à base d'argent dans lequel l'oxyde est dispersé, est durci ou durcissable et en ce que les quantités d'alliage contribuant au durcissement par précipitation d'oxyde, sont contenues en quantités allant jusqu'à 10 % en poids dans l'alliage à base d'argent.

2. Solide composite selon la revendication 1, caractérisé en ce que les éléments d'alliage qui contribuent au durcissement par précipitation sont inclus à 0,05 jusqu'à 2 % en poids dans l'alliage à base d'argent.

3. Solide composite selon la revendication 1, caractérisé en ce que l'alliage à base d'argent contient en vue de l'augmentation de la résistance électrique au moins un des éléments de métal noble (EM) Ru, Rh, Pd, Os, Ir, Pt et/ou Au.

4. Solide composite selon la revendication 3, caractérisé en ce que les éléments de métal noble (EM) sont contenus avec une teneur totale de pas plus de 10 % en poids dans l'alliage d'argent.

5. Solide composite selon l'une des revendications précédentes, caractérisé en ce qu'il s'agit pour l'alliage d'argent, d'un alliage Ag-Mg-Ni ou Ag-EM-Mg-Ni, qui renferme de préférence de 0,1 à 0,25 % en poids de Mg, de 0,1 à 0,25 % en poids de Ni, le reste étant de l'argent ou de l'argent et des éléments de métal noble (EM).

6. Solide composite selon l'une des revendications 1 à 4, caractérisé en ce qu'il s'agit pour l'alliage d'argent, d'un alliage Ag-Mn-Ni ou Ag-EM-Mn-Ni, qui renferme de préférence Mn et Ni, dans une teneur totale allant de 0,5 à 1,5 % en poids, le reste étant de l'argent ou de l'argent et des éléments de métal noble (EM).

7. Solide composite selon l'une des revendications 1 à 3, caractérisé en ce qu'il s'agit pour l'alliage d'argent d'un alliage Ag-Al ou Ag-EM-Al.

8. Solide composite selon l'une des revendications précédentes, caractérisé en ce que l'alliage à base d'argent contient du palladium (Pd) comme élément de métal noble (EM).

9. Solide composite selon l'une des revendications précédentes, caractérisé en ce que l'alliage d'argent est produit par mélange de poudres, de préférence de l'argent en poudre avec une poudre d'oxyde et le cas échéant un métal noble en poudre.

10. Procédé d'obtention d'un solide composite supraconducteur (1) par :
- introduction d'un matériau de supraconducteur (2) en céramique d'oxyde dans une enveloppe (3), dont le matériau consiste en un alliage à base d'argent,
- formage qui réduit la section transversale, et,
- traitement thermique pour la récupération et l'ajustement de la concentration en oxygène,
caractérisé en ce que l'enveloppe (3) consiste en un alliage d'argent durci ou durcissable, dans lequel l'oxyde est dispersé et en ce que la quantité d'alliage qui contribue au durcissement par précipitation d'oxyde est contenue en quantité allant jusqu'à 10 % en poids, dans l'alliage à base d'argent.

11. Procédé selon la revendication 10, caractérisé en ce que avant le traitement thermique pour la récupération et l'ajustement de la concentration en oxygène, un autre traitement thermique est entrepris pour le durcissement de l'alliage d'argent durcissable dans lequel l'oxyde est dispersé.

12. Procédé selon la revendication 10 ou 11, caractérisé en ce que le matériau de supraconducteur (2) en céramique d'oxyde, est précompacté avant l'introduction dans l'enveloppe (3) en particulier par pressage isostatique à froid.

13. Procédé selon la revendication 12, caractérisé en ce que le matériau de supraconducteur (2) compacté est fritté en supplément avant l'introduction dans l'enveloppe (3).

14. Procédé selon l'une des revendications 10 à 13, caractérisé en ce que la déformation qui réduit la section transversale inclut au début une étape de pressage isostatique à froid.

15. Procédé selon l'une des revendications 10 à 14, caractérisé en ce que la déformation qui réduit la section transversale, s'effectue aussi par laminage à chaud.

16. Procédé selon l'une des revendications 10 à 15, caractérisé en ce que la déformation qui réduit la section transversale s'effectue par laminage à pas de "pèlerin".
